# EUROPEAN PATENT APPLICATION

(11) **EP 0 864 928 A1**
(43) Date of publication of application: **16.09.1998**
(21) Application number: 98200421.0
(22) Date of filing: 10.02.1998
(51) Int. Cl.: G03F 7/06

(54) **A correcting agent for a silver imaged lithographic printing plate**

(30) Priority: 11.03.1997 EP 97200722
(71) Applicant: AGFA-GEVAERT N.V., 2640 Mortsel (BE)
(72) Inventor: Deprez, Lode, 2640 Mortsel (BE)

(57) **Abstract**

A bleach-fixing agent for making corrections on silver imaged lithographic printing plates, which work according to the silver salt diffusion transfer reversal mechanism, is disclosed. By limiting the amount of volatile organic solvents, having a boiling point lower than 100°C, comprised in said correcting agent, to a value not higher than 20% by volume and by adjusting the viscosity of same correcting agent to a value higher than 3 mPas, an improved correcting agent is obtained which is characterized by both a short deletion time, required to convert the undesired oleophilic printing areas into hydrophilic ink-rejecting areas, as well as a short drying time of said correcting agent after being applied to the printing plate's surface.

## Description

### FIELD OF THE INVENTION

The present invention relates to an improved correcting agent for silver imaged lithographic printing plates particularly for silver imaged lithographic printing plates obtained according to the silver salt diffusion transfer reversal process.

### BACKGROUND OF THE INVENTION

The method of lithographic platemaking typically comprises the steps of (i) image-wise exposing the photosensitive coating(s) of the printing plate, (ii) developing said exposed plate by treating with processing liquid(s) and (iii), if necessary, making corrections on said exposed and developed printing plate. A preferred method of lithographic platemaking uses the so-called directly exposable plates which are characterized by a high sensitivity to light, allowing the direct exposure of the plate instead of having to use a film intermediate as exposure mask. Especially the silver imaged lithographic printing plates that work according to the diffusion transfer reversal (DTR) process are highly preferred as such plates are positive-working systems having high versatility of being imaged by projection camera's directly from the paste-up copy and by most commonly available laser image-setters currently used in graphic arts applications.

The principles of the DTR process have been described e.g. in US-P-2,352,014 and in the book "Photographic Silver Halide Diffusion Processes" by André Rott and Edith Weyde - The Focal Press - London and New York, (1972). By DTR processing, non-developed silver halide of an information-wise exposed photographic silver halide emulsion layer material is transformed with a so-called silver halide solvent into soluble silver complex compounds which are allowed to diffuse into an image receiving element and are reduced therein with a developing agent, generally in the presence of physical development nuclei, to form a positive silver image having reversed image density values ("DTR image") with respect to the negative black silver image obtained in the exposed areas of the photographic material. Before processing, a typical DTR lithographic printing plate is characterized by a hydrophilic surface, being water-receptive and non-wettable by ink. The positive silver image, formed after processing at the exposed areas of the DTR lithographic printing plate, is hydrophobic and its ink-receptivity is further enhanced by hydrophobizing agents which are present in the processing liquid(s). Thus after processing, the exposed areas of the DTR litographic printing plate are hydrophobic, ink-receptive printing areas and the unexposed areas are hydrophylic, water-receptive non-printing areas.

During lithographic platemaking it is frequently necessary to make corrections on the printing areas of the plate, e.g. when the original contains undesired images or have dust, dirty powders, finger prints or other stains or when shadows are produced by the exposure of a laminated original. Undesired printing areas may also be produced by uneven development or while printing. In the case of silver imaged lithographic printing plates, said correction requires that portions of silver imaged oleophilic ink-receptive areas of the plate are converted into hydrophilic ink-rejecting areas by applying to said areas a reactive composition called 'correcting agent', 'deletion fluid' or 'deletion liquid', 'correcting fluid' or 'correcting liquid', or briefly 'corrector'. In one embodiment, the correcting agent is a liquid being applied with the aid of a felt-tip correcting pen comprising a container which is filled with the correcting agent. An alternative embodiment is a correcting gel, being a correcting liquid containing a thickening agent.

The correcting agents are aqueous solutions or water-solvent mixtures comprising reactive compounds and can be classified in two types, according to the underlying chemical principles. One type renders the silver imaged areas of the developed lithographic printing plate hydrophylic, i.e. ink-rejecting, without removing the DTR silver image. A second type works according to the bleach-fixing mechanism : a bleaching compound, preferably an iron (III) salt, oxidizes the silver image in the presence of a fixing compound, i.e. a silver halide solvent, which is preferably a thiosulphate. Bleach-fixing correcting agents are generally preferred because the stability of the hydrophilicity of the areas deleted by correcting agents of the first type is not retained as well as by correcting agents of the second type.

Prior art correcting agents for silver imaged lithographic printing plates are described in Japanese Patent Application (Kokai) Nos. 06/266114, 06/266113, 06/102672, 06/67440, 03/282476, 01/254962, 51/21901 and 48/92101. These disclosures provide solutions for some of the requirements which have to be met by suitable correctors : no bad odour or adverse effect on the human body or the environment, rapid deletion of the undesired printing areas, good storage stability and no recovery of ink-receptivity at deleted areas while printing. The above mentioned requirements are fulfilled by the correcting agent disclosed in U.S. Patent No. 4,837,122 but further improvement is necessary. Specifically the demand of a corrector, which dries rapidly after being applied to the plate's surface, is difficult to fulfil together with the other above mentioned requirements. Correctors having a short drying time after being applied onto the plate's surface offer the advantage that plates can be handled and even be stacked upon one another immediately after correction, such feature being particularly beneficial when platemaking and printing is performed at different locations. One way of limiting the drying time of the correcting agent after being applied onto the plate's surface is the addition of large amounts of volatile organic solvents, being defined herein as solvents having a boiling point below 100°C at normal atmospheric pressure. Such correcting agents comprising large amounts of volatile solvents, however, are characterized by excessive solvent odours and a long deletion time, required to convert the undesired printing areas into hydrophilic ink-rejecting areas, due to the dilution of the reactive components.

When the correcting agent is applied onto the surface of the lithographic printing plate by means of a felt-tip pen, the amount of correcting agent applied onto the plate's surface is determined by the pressure and the surface area of the tangent plane of the tip making contact with the printing plate. Therefore, the use of correcting pens having a large tip diameter is characterized by a large amount of correcting agent applied. Conventional correcting agents have too long a drying time to be applied by means of such pens having a large tip diameter.

### OBJECTS OF THE INVENTION

It is therefore a first object of the present invention to provide a correcting agent for silver imaged lithographic printing plates which fulfils all the requirements of having no bad odours or other adverse effect on the human body or the environment, of deleting rapidly the undesired printing areas and retaining the hydrophilicity thereby obtained in said areas for a long period of time and of offering excellent storage stability in soluble form, as well as a short drying time after application on the surface of the lithographic printing plate.

It is another object of the invention to provide a felt-tip pen containing the above mentioned correcting agent so that said correcting agent can be applied onto a printing plate's surface, and then deletes the silver imaged areas quickly and dries rapidly even when said pen has a large tip diameter.

Further objects and advantages of the invention will become apparent from the description hereinafter.

### SUMMARY OF THE INVENTION

The above mentioned objects are realised by a correcting agent for deleting hydrophobic silver image areas of lithographic printing plates comprising an iron (III) complex salt of organic acid(s) or phosphonic acid(s) or salts of said acids and a silver halide solvent, characterized in that said correcting agent further comprises an amount of 0 to 20% by volume of one or more volatile organic solvents having a boiling point lower than 100°C at normal athmospheric pressure and a sufficient amount of thickening agent other than gelatin so as to adjust the viscosity of said correcting agent to a value from 3 to 100 milliPascal·second (mPas) at 20°C.

Preferred embodiments of said correcting agent are disclosed in the appending subclaims. Even small amounts of said volatile organic solvents, as low as 2% by volume, may shorten the drying time noticeably. As indicated above, an increase of the amount of volatile organic solvents up to a concentration higher than 20% by volume shortens the drying time of the correcting agent applied onto the plate's surface even further. However correcting agents comprising such large amounts of volatile organic solvents are characterised by excessive odours and a long deletion time required to convert the undesired printing areas into hydrophilic ink-rejecting areas arise . According to this invention it was found that increasing the viscosity of the correcting agent to a value higher than or equal to 3 mPas surprisingly compensates for said limitation of the amount of volatile organic solvents to a concentration not higher than 20% by volume, thereby providing a rapidly drying correcting agent with a short deletion time but without excessive odours. A possible explanation therefore could be the influence of the viscosity of the correcting agent on the thickness of the film applied onto the plate's surface. The upper limit for the viscosity of the correcting agent of 100 mPas is due to practical reasons, since higher values render the correcting agent useless, especially when being applied by a felt-tip pen.

### DETAILED DESCRIPTION OF THE INVENTION

The correcting agents according to this invention work according to the bleach-fixing mechanism which requires the presence of a silver bleaching compound and a silver halide solvent. The bleaching compound is an iron (III) complex salt of organic acid(s) and/or phosphonic acid(s) and/or salts of said acids. References to iron (III) refers to iron in the +3 oxidation state. The iron (III) complex salts are used for oxidizing the silver images utilized as ink-receptive areas and are preferably used in a large amount since the hydrophobizing agents in the processing liquid(s), used for enhancing the oleophilicity, such as mercapto compounds and the like are firmly absorbed to said silver images. Preferably, the iron (III) complex salts are used in an amount of 0.07 to 0.7 mole per litre of correcting agent, more preferably in an amount of 0.15 to 0.35 mole per litre of correcting agent.

The iron (III) complex salts may be formed in situ by making a solution of organic and/or phosphonic acids and/or salts of said acids and inorganic iron (III) salts such as iron (III) sulphate, iron (III) chloride, iron (III) nitrate, iron (III) ammonium sulphate, iron (III) phosphate, etc. Iron (III) complex salts include optional combinations of iron (III) salts of organic or phosphonic acid salts and said inorganic iron (III) salts.

A preferred example of the iron (III) complex salt of an organic acid and salts thereof is an iron (III) complex salt of an aminopolycarboxylic acid and salts thereof. Typical examples of aminopolycarboxylic acids and salts thereof are diethylenetriaminepentaacetic acid and its salts, ethylenediamine-N-(2-oxyethyl)-N,N',N'-triacetic acid and its salts, propylenediaminetetraacetic acid and its salts, nitrilotriacetic acid and its salts, cyclohexanediaminetetraacetic acid and its salts, iminodiacetic acid, dihydroxyethylglycine, ethylenediaminetetrapropionic acid, etc. A more preferred example of aminopolycarboxylic acids and salts thereof are ethylenediaminetetraacetic acid (EDTA) and its salts.

Typical examples of phosphonic acids and salts thereof are diethylenetriaminepentamethylenephosphonic acid and its salts, cyclohexanediaminetetramethylenephosphonic acid and its salts, triethylenetetraminehexamethylenephosphonic acid and its salts, glycoletherdiaminetetramethylenephosphonic acid and its salts, 1,2-diaminopropanetetramethylenephosphonic acid and its salts, methyliminodimethylenephosphonic acid and its salts, 1,3-diaminopropane-2-ol tetramethylenephosphonic acid and its salts, ethylenediaminetetramethylenephosphonic acid and its salts, etc.

Preferably the correcting agent contains an extra amount of organic or phosphonic acid, more preferably between 0.02 and 0.2 mole per litre of correcting agent and most preferably between 0.04 and 0.1 mole per litre of correcting agent. Preferably the organic or phosphonic acid used in the formation of the iron (III) complex salts and the organic or phosphonic acid being present in an extra amount are both either an organic or phosphonic acid, and more preferably they are identical.

The silver halide solvent comprised in the correcting agents according to this invention is preferably a thiosulphate, more preferably sodium or ammonium thiosulphate being present in an amount ranging from 0.5 to 5 mole per litre of correcting agent, most preferably in an amount ranging from 1.0 to 2.5 mole per litre of correcting agent. Other silver halide solvents which may be used according to this invention are e.g. 2-mercaptobenzoic acid, a cyclic imide, an oxazolidone, a thiocyanate, an alkanolamine or a thioether as described furtheron in the present disclosure.

The correcting agent preferably contains a sulphite or a metabisulphite, more preferably sodium sulphite. Said sulphite is preferably present in an amount ranging from 0.06 to 0.6 mole per litre of correcting agent, more preferably in an amount ranging from 0.12 to 0.28 mole per litre of correcting agent, where the metabisulphite is preferably present in an amount ranging from 0.03 to 0.3 mole per litre of correcting agent, more preferably in an amount ranging from 0.06 to 0.14 mole per litre of correcting agent.

The correcting agent according to this invention preferably contains a bleach accelerating agent, being an organic heterocyclic compound having a mercapto or thione group, examples of which have been disclosed in British Patent Specification No. 1,138,842 and Japanese Patent Application (Kokai) Nos. 06/266114, 06/266113, 06/102672 and 06/67440. Preferably, said organic heterocyclic compound is a non-ionic compound, containing at least two nitrogen atoms, most preferably at least three nitrogen atoms in the heterocyclic nucleus and preferably carries no other hydrophilic substituent besides said mercapto group or thione group, as disclosed in EP-A 779,554. Preferably, the bleach accelerating agents are used in an amount ranging from 0.08 to 0.2 mole per litre correcting agent. Examples of highly preferred accelerators are given in table 1.

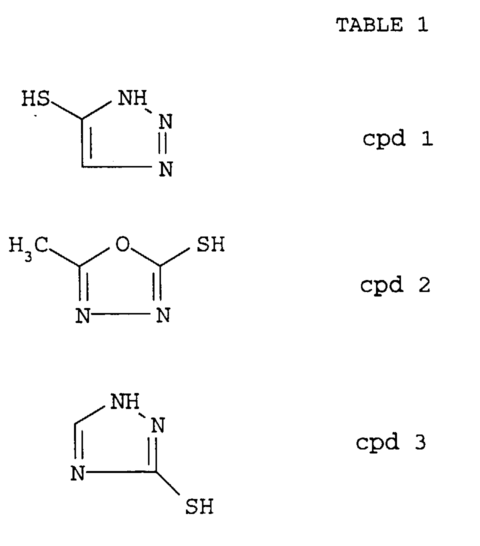

The correcting agent according to this invention may contain one or more organic solvents such as alcohols, ethers, amides, etc. up to an amount of 50% by volume versus the correcting agent. The correcting agents of the present invention preferably contain volatile organic solvents, having a boiling point lower than 100°C at normal atmospheric pressure, up to a total volume not higher than 20% of the total volume of the correcting agent comprising said solvents. Preferred examples of said volatile organic solvents are methanol, ethanol, n-propanol and iso-propanol. The correcting agent according to this invention may also comprise organic solvents having a boiling point higher than 100°C, of which a preferred example is 1-methoxy-2-propanol.

The correcting agent according to this invention contains one or more thickening agents other than gelatin in an amount required to adjust the viscosity of the correcting agent to a value in the range from 3 to 100 mPas and more preferably from 5 to 100 mPas, said viscosity being measured by the well-known method using a capillary viscometer, comprising the steps of (i) thermostatising the correcting agent at 20°C while stirring; (ii) pipetting a sufficient amount of correcting agent while stirring; (iii) transferring said amount to a calibrated capillary viscometer; (iv) allowing the correcting agent to flow by gravity through said capillary, thereby measuring the volumetric flow rate which is inversely proportional to the viscosity of the correcting agent as described by Poiseuille's law.

Any thickening agent other than gelatin may be used to adjust the viscosity of the correcting agents according to this invention. Gelatin is not suitable as a thickening agent because it easily precipitates from the solution due to the high ionic strength of correcting agents according to the present invention. Also the typical pH value of these correcting agents may jeopardize the solubility of gelatin, said pH value being preferably between 5.5 and 8.5 and more preferably in the range between 6 and 8. This pH value is preferably obtained by use of a buffer e.g. a phosphate buffer, a citrate buffer, an ammonium buffer or mixtures thereof. Another problem associated with the use of gelatin as a thickening agent for correcting agents is its low hydrophilicity. Areas of printing plates, whereon a correcting agent comprising gelatin as a thickener has been applied, are characterized by a too low hydrophilicity and, as a consequence, a complete removal of the ink acceptance at deleted areas of the printing plate is not achieved. Therefore, highly hydrophilic thickeners are preferred.

Preferred thickeners for the purpose of this invention are high molecular weight hydrophilic polymers, e.g. modified polyacrylamides according to Formula I or salts thereof 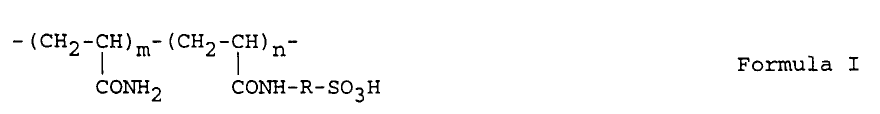 wherein R is an alkylene or substituted alkylene group, an alkenylene or substituted alkenylene group, an arylene or a substituted arylene group, wherein m and n are positive integers and wherein both monomeric units are arranged so as to form a random or block-copolymer. A highly preferred example of thickener according to Formula I is a random copolymer according to the formula of Cpd 4, wherein the m:n ratio is about 20:80.

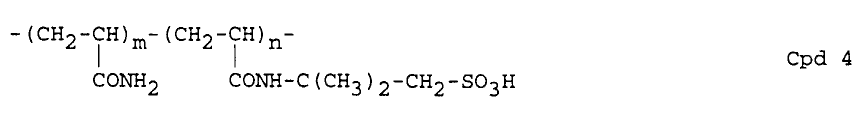

A second example of highly preferred thickening agents used to adjust the viscosity of the correcting agents according to this invention are synthetic clay minerals or mixtures thereof. Clays are hydrous silicates, comprising combinations of two basic structural units. One unit consists of silica tetrahedrons, in which each tetrahedron is made up of a silicon atom equidistant from four oxygen atoms of hydroxyl ions arranged in the form of a tetrahedron with the silicon atom at the centre. The other structural unit consists of two sheets of closely packed oxygen atoms or hydroxyl ions in which aluminium, iron, lithium, magnesium or other metal ions are octahedrally coordinated. Because of the sheetlike nature of their structural units, clay minerals are tubular or elongate or both and some are fibrous. Besides the ability of clay minerals to hold certain cations and anions which are readily exchangeable for other cations and anions, another important property is their capability of taking up water and organic liquids between the composite layers.

Highly preferred synthetic clays for the purposes of this invention are LAPONITE RD and LAPONITE JS, trade mark products of LAPORTE INDUSTRIES Limited, London. Organophilic clays and process for the production thereof have been described in European Patent No. 161,411. LAPONITE JS is described as a synthetic layered hydrous sodium lithium magnesium fluoro-silicate incorporating an inorganic polyphosphate peptiser. The said fluoro-silicate appears as free flowing white powder and hydrates well in water to give virtually clear and colourless colloidal dispersions of low viscosity, also called "sols". LAPONITE RD is described as a synthetic layered hydrous sodium lithium magnesium silicate with analogous properties as LAPONITE JS. Laponite clays as synthetic inorganic thickening agents for aqueous solutions of polar organic compounds have been presented at the Symposium on "Gums and Thickeners", organised by the Society of Cosmetic Chemists of Great Britain, held at Oxford, on October 14, 1969. In Laporte Inorganic Laponite Technical Bulletin L104/90/A a complete review about the structure and the chemistry of LAPONITE and its relationship to natural clays is presented. Further in Laporte Inorganic Laponite Technical Bulletin L106/90/c properties, preparation of dispersions, applications of LAPONITE and the product range are disclosed.

The correcting agent preferably contains a surfactant, more preferably an amphoteric surfactant as described in US-P 4,837,122, most preferably n.C₁₆H₃₃N⁺(CH₃)₂CH₂COO⁻ (sold as Ambiteric H by LONZA, Switserland). Said surfactant is preferably used in an amount ranging from 0.3 g to 3 g per litre of correcting agent, more preferably in an amount ranging from 0.6 g to 1.5 g per litre of correcting agent.

The correcting agent may contain water soluble bromides and/or water soluble iodides up to the amount wherein said bromides and/or iodides are soluble in the correcting agent. Examples of such water soluble bromides and iodides are potassium bromide or iodide, sodium bromide or iodide, ammonium bromide or iodide.

The correcting agent according to the present invention is preferably applied onto the surface of the printing plate by means of a felt-tip pen. Typically, said pen tip is characterized by a cylindrical shape being cut at an angle with the tip's long axis, thereby forming a tangent plane of which the surface area making contact with the printing plate is proportional to the diameter of the tip's cylindrical shape. Normally the pen tip diameter is larger than 0.5 mm since the use of smaller tips involves a risk of scratching the printing plate's surface. Especially when being applied by means of correcting pens having a large tip diameter up to 5 mm, conventional correcting agents are characterized by either a long deletion time required to convert the undesired printing areas into hydrophilic ink-rejecting areas or either a long drying time of the correcting agent after being applied onto the printing plate's surface. A correcting agent according to the present invention offers the advantage that, even when applied in large amounts by means of a felt-tip pen having a large tip diameter, said correcting agent fulfils both the requirements of having a short deletion time and a short drying time.

The felt-tip pen comprising a correcting agent according to the present invention is preferably packed with a packaging material characterized by an oxygen permeability of not more than 2000 ml/m²·day·atm and a water vapour transmission rate of not more than 40 g/m²·day so as to guarantee that the content of volatile solvents and the viscosity of the correcting agent remain unchanged inside the package and that no oxidation of the components comprised in said correcting agent can occur.

The silver imaged lithographic printing plate for use in this invention is preferably prepared according to the principles of the DTR process. The DTR image can be formed in the image receiving layer of a sheet or web material which is a separate element with respect to the photographic silver halide emulsion material (a so-called two-sheet DTR element) or in the image receiving layer of a so-called single-support element, also called mono-sheet element, which contains at least one photographic silver halide emulsion layer integral with an image receiving layer in waterpermeable relationship therewith. It is the latter mono-sheet type which is preferred for the preparation of offset printing plates by the DTR method.

Two preferred embodiments of a mono-sheet DTR offset printing plates, for which the correcting agent of the present invention is used, will be described in the present disclosure. According to a first type, disclosed in e.g. US-P 4,722,535 and GB 1,241,661, an imaging element is provided comprising a support provided in the order given with a silver halide emulsion layer and a layer containing physical development nuclei serving as the image-receiving layer in water permeable relationship with said emulsion layer. After information-wise exposure and development the imaged element is used as a printing plate without the removal of the emulsion layer.

Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or complexed silver ions.

Supports suitable for use in said imaging elements may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide. Metal supports e.g. aluminium may also be used.

The photographic silver halide emulsions can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al. in "Making and Coating Photographic Emulsion", The Focal Press, London (1966). According to the present invention the emulsion or emulsions preferably consist principally or totally of silver chloride while a fraction of silver bromide may be present ranging from 0.1 mole % to 40 mole %. When the fraction of silver bromide is 5% or more, the emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated. The average size of the silver halide grains may range from 0.10 to 0.70 µm , preferably from 0.25 to 0.45 µm. Preferably during the precipitation stage Iridium and/or Rhodium containing compounds or a mixture of both are added. The concentration of these added compounds ranges from 10⁻⁸ to 10⁻³ mole per mole of AgNO₃, preferably between 0.5x10⁻⁷ and 10⁻⁵ mole per mole of AgNO₃.

The silver halide emulsions may be chemically sensitised according to the procedures described in e.g. "Chimie et Physique Photographique" by P. Glafkides, in "Photographic Emulsion Chemistry" by G.F. Duffin, in "Making and Coating Photographic Emulsion" by V.L. Zelikman et al, and in "Die Grundlagen der Photographischen Prozesse mit Silberhalogeniden" edited by H. Frieser and published by Akademische Verlagsgesellschaft (1968). As described in said literature chemical sensitisation can be carried out by effecting the ripening in the presence of small amounts of compounds containing sulphur, selenium or tellurium e.g. thiosulphate, thiocyanate, thiourea, selenosulphate, selenocyanate, selenoureas, tellurosulphate, tellurocyanate, sulphites, mercapto compounds, and rhodamines. In a preferred embodiment, these compounds are applied in combination with a noble metal salt, preferably a gold complex salt, but also salts of platinum, palladium and iridium as described in U.S. Patent No. 2 448 060 and British Patent No. 618 061 may be used. Additions of sulphur and/or selenium and/or tellurium and gold may be carried out consecutively or simultaneously. In the latter case the addition of goldthiosulphate, goldselenosulphate or goldtellurosulphate compounds may be recommended. Optionally, small amounts of compounds of Rh, Ru, Pb, Cd, Hg, or Tl can be added.

Also reductors may be added as chemically sensitising agents, e.g. tin compounds as described in British Patent No. 789 823, amines, hydrazine derivatives, formamidine-sulphinic acids, and silane compounds. The chemical sensitisation can also proceed in the presence of phenidone and/or its derivatives, a dihydroxybenzene as hydroquinone, resorcinol, catechol and/or a derivative(s) thereof, one or more stabiliser(s) or antifoggant(s), one or more spectral sensitiser(s) or combinations of said ingredients.

The silver halide emulsions of the DTR element can be spectrally sensitized according to the spectral emission of the exposure source for which the DTR element is designed. Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes. In the case of a conventional light source, e.g. tungsten light, a green sensitizing dye is needed. In case of exposure by an argon ion laser a blue sensitizing dye is incorporated. In case of exposure by a red light emitting source, e.g. a LED or a He/Ne laser a red sensitizing dye is used. In case of exposure by a semiconductor laser special spectral sensitizing dyes suited for the near infra-red are required. Suitable infra-red sensitizing dyes are disclosed in i.a. US-P 2,095,854, 2,095,856, 2,955,939, 3,482,978, 3,552,974, 3,573,921, 3,582,344, 3,623,881 and 3,695,888. A preferred blue sensitizing dye, green sensitizing dye, red sensitizing dye and infrared sensitizing dye in connection with the present invention are described in EP-A 554,585.

To enhance the sensitivity in the red or near infra-red region use can be made of so-called supersensitizers in combination with red or infra-red sensitizing dyes. Suitable supersensitizers are described in Research Disclosure Vol 289, May 1988, item 28952. The spectral sensitizers can be added to the photographic emulsions in the form of an aqueous solution, a solution in an organic solvent or in the form of a dispersion.

The silver halide emulsions may contain the usual emulsion stabilizers. Suitable emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilizers are i.a. heterocyclic mercapto compounds.

The silver halide emulsions may contain pH controlling ingredients. Preferably the emulsion layer is coated at a pH value near the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

More details about the composition, preparation and coating of silver halide emulsions can be found in e.g. Product Licensing Index, Vol. 92, December 1971, publication 9232, p. 107-109.

The layer containing physical development nuclei can be free of hydrophilic binder but preferably comprises amounts up to e.g. 80% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form.

Between the support and the silver halide emulsion layer there is preferably provided a base layer that preferably contains an anti-halation substance such as e.g. light-absorbing dyes absorbing the light used for image-wise exposure of the imaging element. As alternative finely divided carbon black can be used as an anti-halation substance. On the other hand, in order to gain sensitivity, light reflecting pigments, e.g. titaniumdioxide can be present in the base layer. Further this layer can contain hardening agents, matting agents, e.g. silica particles, and wetting agents. Suitable matting agents preferably have an average diameter of 2-10 µm and more preferably between 2 µm and 5 µm. The matting agents are generally used in a total amount in the imaging element of 0.1 g/m² to 2.5 g/m². At least part of these matting agents and/or light reflection pigments may also be present in the silver halide emulsion layer and/or in the cover layer. As a further alternative the light reflecting pigments may be present in a separate layer provided between the antihalation layer and the photosensitive silver halide emulsion layer. Like the emulsion layer the base layer is coated preferably at a pH value near the isoelectric point of the gelatin in the base layer.

In a preferred embodiment in connection with the present embodiment a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value near the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the imaging element, especially when the binder used is gelatin, can be hardened with appropriate hardening agents such as those of the vinylsulfone type e.g. methylenebis(sulfonylethylene), aldehydes e.g. formaldehyde, glyoxal, and glutaraldehyde, N-methylol compounds e.g. dimethylolurea and methyloldimethylhydantoin, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952. Preferably used hardening agents are of the aldehyde type. The hardening agents can be used in a wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The imaging element used according to the present embodiment may further comprise various kinds of surface-active agents in the silver halide emulsion layer or in at least one other hydrophilic colloid layer. Examples of suitable surface-active agents are described in e.g. EP 545452. Preferably compounds containing perfluorinated alkyl groups are used.

The imaging element of the present embodiment may further comprise various other additives such as e.g. compounds improving the dimensional stability of the imaging element, UV-absorbers, spacing agents and plasticizers.

Suitable additives for improving the dimensional stability of the imaging element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, alpha-beta-unsaturated dicarboxylic acids, hydroxyalkyl (meth)acrylates, sulphoalkyl (meth)acrylates, and styrene sulphonic acids.

The imaging element can be information-wise exposed in an apparatus according to its particular application. A wide choice of cameras for exposing the photosensitive silver halide emulsion exists on the market. Horizontal, vertical and darkroom type cameras and contact-exposure apparatus are available to suit any particular class of reprographic work. The imaging element can also be exposed with the aid of i.a. laser recorders and cathode rays tubes.

The processing liquid used for developing the DTR imaging element are alkaline solutions which contain a silver halide solvent. Preferably the silver halide solvent is used in an amount between 0.01% by weight and 10% by weight and more preferably between 0.05% by weight and 8% by weight. Suitable silver halide solvents for use in connection with the present invention are e.g. 2-mercaptobenzoic acid, cyclic imides, oxazolidones and thiosulphates. Silver halide solvents that are preferably used in connection with the present invention are thiocyanates and alkanolamines.

Alkanolamines that are suitable for use in connection with the present invention may be of the tertiary, secondary or primary type. Examples of alkanolamines that may be used in connection with the present invention correspond to the following formula: 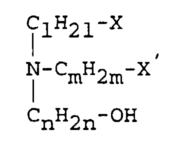 wherein X and X^{'} independently represent hydrogen, a hydroxyl group or an amino group, l and m represent 0 or integers of 1 or more and n represents an integer of 1 or more. Preferably used alkanolamines are e.g. N-(2-aminoethyl)ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol, etc. or mixtures thereof. According to the present invention the alkanolamines are preferably present in the processing liquid. However part or all of the alkanolamine can be present in one or more layers of the imaging element.

A further suitable type of silver halide solvents are thioether compounds. Preferably used thioethers correspond to the following general formula:

Z-(R^{¹}-S)ₜ-R^{²}-S-R³-Y

wherein Z and Y each independently represents hydrogen, an alkyl group, an amino group, an ammonium group, a hydroxyl, a sulfo group, a carboxyl, an aminocarbonyl or an aminosulfonyl, R¹, R² and R³ each independently represents an alkylene that may be substituted and optionally contain an oxygen bridge and t represents an integer from 0 to 10. Examples of thioether compounds corresponding to the above formula are disclosed in e.g. US-P-4,960,683 and EP-A 547,662, which therefor are incorporated herein by reference.

Still further suitable silver halide solvents are meso-ionic compounds. Preferred meso-ionic compounds for use in connection with the present invention are triazolium thiolates and more preferred 1,2,4-triazolium-3-thiolates. Preferably at least part and more preferably all of the meso-ionic compound is present in the processing liquid used for developing the image-wise exposed imaging element. Preferably the amount of meso-ionic compound in the processing liquid is between 0.1 mmol/l and 25 mmol/l and more preferably between 0.5 mmol/l and 15 mmol/l and most preferably between 1 mmol/l and 8 mmol/l. However the meso-ionic compound may be incorporated in one or more layers comprised on the support of the imaging element. The meso-ionic compound is in that case preferably contained in the imaging element in a total amount between 0.1 and 10 mmol/m², more preferably between 0.1 and 5 mmol/m² and most preferably between 0.5 and 1.5 mmol/m². More details are disclosed in EP-A-0,554,585

The processing liquid used in accordance with the present invention preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate etc. Suitable organic alkaline substances are e.g. alkanolamines. In the latter case the alkanolamines will provide or help maintain the pH and serve as a silver halide complexing agent.

The processing liquid may also contain (a) developing agent(s). In this case the processing liquid is called a developer. On the other hand some or all of the developing agent(s) may be present in one or more layers of the imaging element. When all of the developing agents are contained in the imaging element the processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidone-type developing agent and/or p-monomethylaminophenol. Particularly useful auxiliary developing agents are the 1-phenyl-3-pyrazolidones. Even more preferred, particularly when they are incorporated into the imaging element are 1-phenyl-3-pyrazolidones of which the aqueous solubility is increased by a hydrophilic substituent such as e.g. hydroxy, amino, carboxylic acid group, sulphonic acid group etc. Examples of 1-phenyl-3-pyrazolidones subsituted with one or more hydrophilic groups are e.g. 1-phenyl-4,4-dimethyl-2-hydroxy-3-pyrazolidone, 1-(4-carboxyphenyl)-4,4-dimethyl-3-pyrazolidone etc. However other developing agents ban be used.

At least the auxiliary developing agents are preferably incorporated into the imaging element, preferably in the silver halide emulsion layer of the imaging element, in an amount of less than 150 mg/g of silver halide expressed as AgNO₃, more preferably in an amount of less than 100 mg/g of silver halide expressed as AgNO₃.

The processing liquid used for developing an imaging element preferably also contains hydrophobizing agents for improving the hydrophobicity of the silver image obtained in the image receiving layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobizing agents for use in accordance with the present invention are e.g. those described in US-P 3,776,728, and US-P 4,563,410. Preferred compounds correspond to one of the following formulas: 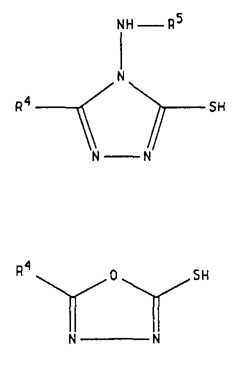 wherein R⁵ represents hydrogen or an acyl group, R⁴ represents alkyl, aryl or aralkyl. Most preferably used compounds are compounds according to one of the above formulas wherein R⁴ represents an alkyl containing 3 to 16 C-atoms.

According to the present invention the hydrophobizing agents are contained in the processing liquid in an amount of at least 0.1 g/l, more preferably at least 0.2 g/l and most preferably at least 0.3 g/l. The maximum amount of hydrophobizing agents will be determined by the type of hydrophobizing agent, type and amount of silver halide solvents etc. Typically the concentration of hydrophobizing agent is preferably not more than 1.5 g/l and more preferably not more than 1 g/l.

The processing liquid preferably also contains a preserving agent having antioxidation activity, e.g. sulphite ions provided e.g. by sodium or potassium sulphite. For example, the aqueous solution comprises sodium sulphite in an amount ranging from 0.15 to 1.0 mole/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners. In accordance with the present invention it is furthermore preferred to use a spreading agent or surfactant in the processing liquid to assure equal spreading of the processing liquid over the surface of the imaging element. Such a surfactant should be stable at the pH of the processing liquid and should assure a fast overall wetting of the surface of the imaging element. A surfactant suitable for such purpose is e.g. a fluor containing surfactant such as e.g. C₇F₁₅COONH₄. It is furthermore advantageous to add glycerine to the processing liquid so as to prevent crystallization of dissolved components of said processing liquid.

Development acceleration can be accomplished by addition of various compounds to the processing liquid and/or one or more layers of the imaging element, preferably polyalkylene derivatives having a molecular weight of at least 400 such as those described in e.g. US-P 3,038,805 - 4,038,075 - 4,292,400 - 4,975,354.

Subsequent to the development in a processing liquid in accordance with the present invention, the surface of the printing plate is preferably neutralized using a neutralization liquid. A neutralization liquid generally has a pH between 5 and 8. The neutralization liquid preferably contains a buffer e.g. a phosphate buffer, a citrate buffer or mixture thereof. The neutralization solution can further contain bactericides, substances which influence the hydrophobic / hydrophilic balance of the printing plate obtained after processing of the DTR element, e.g. hydrophobizing agents as described above, silica and wetting agents, preferably compounds containing perfluorinated alkyl groups.

A first embodiment of a lithographic plate which works according to the DTR mechanism is thus obtained.

According to another embodiment a lithographic printing plate can be obtained by means of the DTR process using an imaging element comprising in the order given a hydrophilic surface of a support, a layer containing physical development nuclei and a silver halide emulsion layer. Said hydrophilic surface of a support can be a hardened hydrophilic layer, containing a hydrophilic binder and a hardening agent coated on a flexible support.

Such hydrophilic binders are disclosed in e.g. EP-A 450,199, which therefor is incorporated herein by reference. Preferred hardened hydrophilic layers comprise partially modified dextrans or pullulan hardened with an aldehyde as disclosed in e.g. EP-A 514,990 which therefore is incorporated herein by reference. More preferred hydrophilic layers are layers of polyvinyl alcohol hardened with a tetraalkyl orthosilicate and preferably containing SiO₂ and/or TiO₂ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199 which therefor are incorporated herein by reference.

Flexible supports e.g. a paper support or a resin support are described above.

Said hydrophilic surface of a support may be a hydrophilic metallic support e.g. an aluminum foil. The aluminum support of the imaging element for use in accordance with the present invention can be made of pure aluminum or of an aluminum alloy, the aluminum content of which is at least 95%. The thickness of the support usually ranges from about 0.13 to about 0.50 mm. The preparation of aluminum or aluminum alloy foils for lithographic offset printing comprises the following steps : graining, anodizing, and optionally sealing of the foil. Graining and anodization of the foil are necessary to obtain a lithographic printing plate that allows to produce high-quality prints. Sealing is not necessary but may still improve the printing results. Preferably the aluminum foil has a roughness with a CLA value between 0.2 and 1.5 µm, an anodization layer with a thickness between 0.4 and 2.0 µm and is sealed with an aqueous bicarbonate solution. More details on the preparation of a grained, anodized and sealed aluminum foil are given in US-P 3,861,917 and in the documents referred to therein.

To promote the image sharpness and, as a consequence thereof, the sharpness of the final printed copy, the anodization layer may be coloured in the mass with an antihalation dye or pigment e.g. as described in JA-Pu-58-14,797.

The silver halide emulsion is prepared as described above. As binder in the silver halide emulsion layer(s) in connection with the present invention a hydrophilic colloid may be used, usually a protein, preferably gelatin. Gelatin can, however, be replaced in part or integrally by synthetic, semi-synthetic, or natural polymers. Preferably the silver halide emulsion layer contains at least one gelatin species whereof a 10 % by weight aqueous solution at 36°C and pH 6 has a viscosity lower than 20 mPas at a shearing rate of 1000 s⁻¹ combined with a gelatin of a higher viscosity. The weight ratio of said low viscosity gelatin versus the gelatin of a higher viscosity is preferably > 0.5.

Preferably the gelatin layer(s) is(are) substantially unhardened. Substantially unhardened means that when such gelatin layer is coated on a subbed polyethylene terephtalate film base at a dry thickness of 1.2 g/m², dried for 3 days at 57°C and 35% R.H. and dipped in water of 30°C, said gelatin layer is dissolved for more than 95 % by weight within 5 minutes.

The imaging element of the present embodiment may be imaged using a camera-exposure or a scanning exposure as described above followed by a development step in the presence of development agent(s) and silver halide solvent(s) as described above so that a silver image is formed in the physical development nuclei layer. Subsequently the silver halide emulsion layer and any other optional hydrophilic layers are removed by e.g. rinsing the imaged element with water, preferably between 30°C and 50°C so that the silver image is exposed.

To facilitate the removal of the silver halide emulsion layer it is advantageous to provide a layer between the layer containing physical development nuclei and the silver halide emulsion layer comprising a hydrophilic non-proteinic film-forming polymer e.g. polyvinyl alcohol, polymer beads e.g. poly(meth)acrylate beads, particles of a water insoluble inorganic compound having a number average size not lower than 0.1 µm, alkali insoluble non-polymeric organic compounds having a melting point of at least 50°C and a number average size between 0.1 µm and 10 µm and particles of an alkali insoluble polymer obtainable by polycondensation with a number average size between 0.02 µm and 10 µm. Such type of layers are disclosed in EP-A-483415, EP-A-410500, EP-A-723195, EP-A-750227 and EP-A-95203052.6.

Finally said exposed imaged surface of the hydrophilic support is treated with a composition often called finisher, which comprises at least one compound enhancing the ink-receptivity and/or lacquer-receptivity of the silver image and at least one compound that improves the ink-repelling characteristics of the hydrophilic surface. Suitable ingredients for the finisher are e.g. organic compounds containing a mercapto group such as the hydrophobizing compounds referred to hereinbefore for the processing liquid. Said (a) hydrophobizing agent(s) is(are) comprised in the finisher preferably in a total concentration between 0.1 g/l and 10 g/l, more preferably in a total concentration between 0.3 g/l and 3 g/l.

Additives improving the oleophilic ink-repellency of the hydrophilic surface areas are e.g. carbohydrates such as acid polysaccharides like gum arabic, carboxymethylcellulose, sodium alginate, propylene glycol ester of alginic acid, hydroxyethyl starch, dextrin, hydroxyethylcellulose, polyvinyl pyrrolidone, polystyrene sulphonic acid, polyvinyl alcohol and preferably polyglycols, being the reaction products of ethyleneoxide and/or propyleneoxide with water or an alcohol. Optionally, hygroscopic substances e.g. sorbitol, glycerol, tri(hydroxyethyl)ester of glycerol, and turkish red oil may be added.

A second embodiment of a lithographic plate which works according to the DTR mechanism is thus obtained.

The invention will now be illustrated by the following examples, describing preferred embodiments, without however the intention to limit the invention thereto. Indeed it will be apparent to those skilled in the art that numerous modifications can be made therein without departing from the scope of the invention as defined in the appending claims.

### EXAMPLES

### Preparation of the coating solutions

A silver chlorobromide emulsion composed of 98.2 mole% of chloride and 1.8 mole% of bromide was prepared by the double jet precipitation method. The average silver halide grain size was 0.4 µm (diameter of a sphere with equivalent volume) and contained rhodium ions as internal dopant. 4-hydroxy-6-methyl-1,3,3a,7-tetraazaindene was added as stabilizer in an amount of 290 mg/mole of silver halide and prior to coating the emulsion was orthochromatically sensitized by adding a green sensitizing dye.

A base layer coating solution was prepared having the following composition (percentages by weight) :

| | |
|---|---|
| gelatin | 5.5% |
| carbon black | 0.76% |
| silica particles (5µm) | 1.6% |

### Preparation of the silver imaged lithographic printing plate

The emulsion coating solution and base layer coating solution were simultaneously coated by means of the slide hopper coating technique to a polyethylene terephthalate support. The emulsion layer was coated such that the silver halide coverage expressed as AgNO₃ was 1.5 g/m² and the gelatin content was 1.5 g/m². The emulsion layer further contained 0.15 g/m² of 1-phenyl-4,4'-dimethyl-3-pyrazolidone, 0.25 g/m² of hydroquinone and 100 mg/m² of formaldehyde. The base layer was coated such that the transmission density of the packet of the support and the base layer was 0.65.

The thus obtained element was dried and subjected to a temperature of 40°C for 5 days and then the emulsion layer was overcoated with a layer containing PdS as physical development nuclei, hydroquinone at 0.4 g/m² and formaldehyde at 100 mg/m².

### Preparation of processing solutions

The following processing solutions were prepared :

| Activator | |
|---|---|
| sodium hydroxide | 30 g |
| sodium sulphite anh. | 35 g |
| 2-aminoethyl-aminoethanol | 20 ml |
| 1-methyl, 4-allyl, 5-methyl-1,2,4-triazolium-3-thiolate | 1.1 g |
| 2-mercapto-5-n.heptyl-oxa-3,4-diazole | 150 mg |
| water to make | 1 litre |

| Neutralization solutions | |
|---|---|
| NaH₂PO₄.2H₂O | 40 g |
| Non-ionic surfactant | 200 mg |
| Compound A^{a)} | 800 mg |
| Triethanolamine | 10 ml |
| Sodium benzoate | 1 g |
| Sodium sulphite | 4 g |
| Turpinal 2NZ^{b)} | 1 g |
| Ethylenediamine-tetraacetic acid sodium salt | 1 g |
| water to make | 1 litre |
| pH | 6.0 |

| | |
|---|---|
| a) Compound A is a mercaptotetrazole substituted in the 1-position with -CH₂CON(n.C₄H₉)₂. | |
| b) Turpinal 2NZ is a trade name of Henkel, Belgium for phosphonic acid, (1-hydroxyethylidene)bis-, disodium salt. | |

The imaging element was exposed with a test original and processed with the above described activator for 20 seconds at 30°C, then neutralized at 25 °C with the neutralization solution described above, and subsequently divided into eight samples of silver imaged lithographic printing plate. After drying said samples during 2 hours, eight different correcting agents described hereinafter were tested, each on one of the printing plate samples, by applying said correcting agents by means of a felt-tip pen, having a cylindrical tip diameter of 4 mm and being filled with 2.8 ml of one of the correcting agents. The tests were executed according to the following procedure : (i) each correcting agent was applied three times by means of the above mentioned felt-tip pen onto the same area at the image side of one of the printing plate samples, more specifically onto one area, where a positive DTR silver image was formed; (ii) the time required to delete the DTR silver image was measured by looking through the sample from the back side to a light source, thereby visually establishing the time necessary to render the area at which the correcting agent was applied more transparent than the surrounding areas on which no correcting agent was applied; and (iii) then the drying time of the correcting agent was measured by looking to the reflection of a light source at the image side of the sample, thereby visually establishing the time necessary to render the area at which the correcting agent was applied completely mat, being an indication of a dry surface.

The eight different correcting agents were each prepared by adding the compounds, indicated in Table 2, to the following basic composition, in Table 2 referred to as "Compos. I" :

| | |
|---|---|
| water | 110 ml |
| 1,2,3-mercaptotriazole | 2.5 g |
| EDTA, tetra-sodium salt | 5 g |
| sodium sulphite | 5 g |
| citric acid, 1-aqua | 2.2 g |
| sodium hydroxide | 600 mg |
| ammonium thiosulphate, 59% aqueous solution | 64 ml |
| Ambiteric H ^{a)}, 10% aqueous solution | 1 ml |
| EDTA, mono-Fe³⁺,mono-NH₄⁺ salt, 53% aq. solution | 20 ml |
| pH brought with sulphuric acid at | 7.1 |

| | |
|---|---|
| a) formula given above. | |

The volatile organic solvents referred to in Table 2 are defined as mentioned above, i.e. solvents having a boiling point lower than 100°C at normal atmospheric pressure, e.g. methanol (65°C), ethanol (78.5°C) and n-propanol (97.4°C). 1-methoxy-2-propanol has a boiling point of 118°C. The thickeners Cpd 4 and LAPONITE RD have been described in detail above.

From Table 2 it can be concluded that adding volatile solvents to an amount higher than 20% by volume indeed decreases the drying time but also increases the deletion time (corrector 4 compared to correctors 1 and 2). When limiting the amount of volatile solvents to values not higher than 20% by volume, the increase of drying time can be compensated by adding thickening agents so as to adjust the viscosity of the correcting agent to values higher than 3 mPas (correctors 5, 6 and 7). Corrector 6 has a very short drying time, due to the presence of 14% by volume of volatile solvents and the viscosity being higher than 3 mPas. Corrector 8, having an amount of volatile solvents higher than 20% and a viscosity higher than 3 mPas, is also characterized by a very short drying time though the deletion time is too long. Thus it can be concluded that a short drying time and a short deletion time is obtained when both conditions of having an amount of volatile solvents not higher than 20% by volume and a viscosity higher than 3 mPas are met, as stated in the following claims.

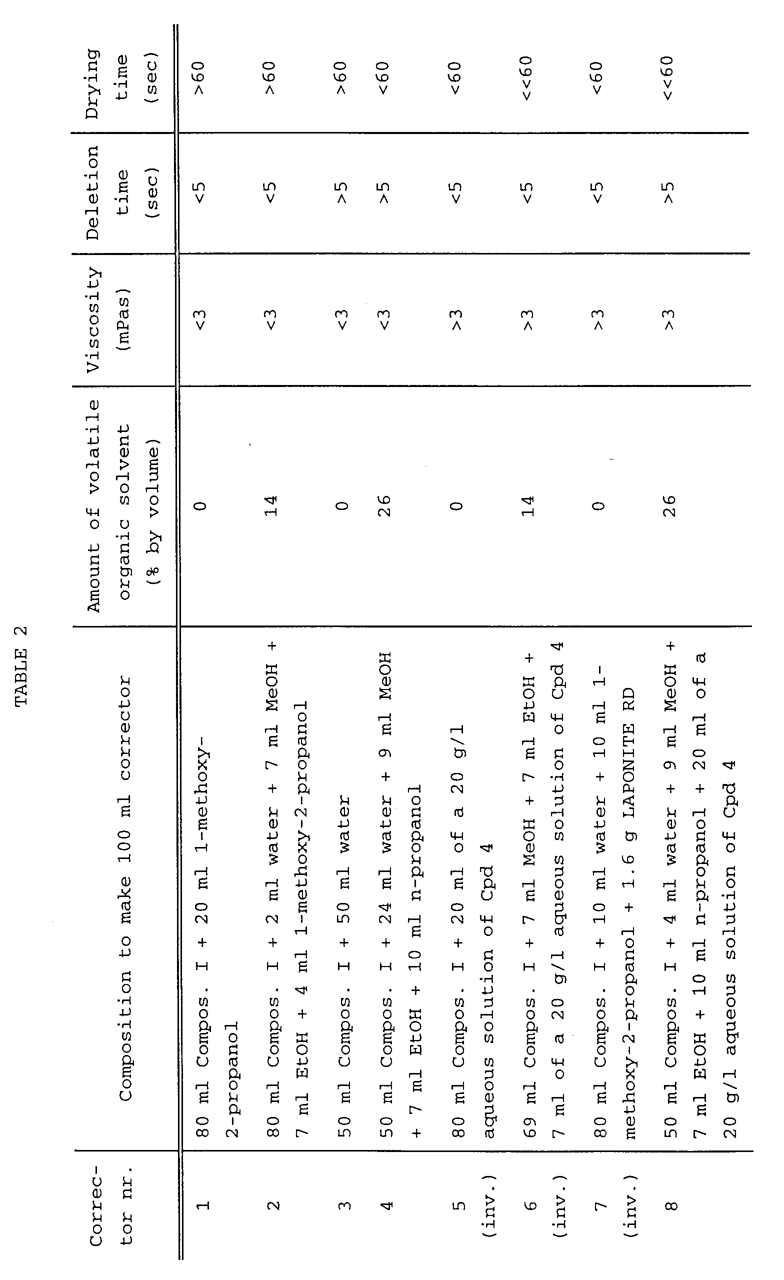

## Claims

1. A correcting agent for deleting hydrophobic silver image areas of lithographic printing plates comprising an iron (III) complex salt of organic acid(s) or phosphonic acid(s) or salts of said acids and a silver halide solvent, characterized in that said correcting agent comprises an amount of 0 to 20% by volume of one or more organic solvents having a boiling point lower than 100°C and a sufficient amount of hydrophilic thickening agent other than gelatin so as to adjust the viscosity of said correcting agent to a value from 3 to 100 milliPascal·second at 20°C.

2. A correcting agent according to claim 1 wherein the viscosity ranges from 5 to 100 milliPascal·second at 20°C.

3. A correcting agent according to claim 1 or 2 wherein the amount of one or more organic solvents having a boiling point lower than 100°C is from 2 to 20% by volume.

4. A correcting agent according to any of the preceding claims, wherein the iron (III) complex salt is a salt of an aminopolycarboxylic acid and the amount of said iron (III) complex salt ranges from 0.07 to 0.7 mole per litre of the correcting agent.

5. A correcting agent according to claim 4, wherein the aminopolycarboxylic acid is ethylenediaminetetraacetic acid (EDTA).

6. A correcting agent according to any of the preceding claims, wherein an extra amount of organic acid or phosphonic acid or the salt(s) of said acids is present, said extra amount ranging from 0.02 to 0.2 mole per litre of the correcting agent.

7. A correcting agent according to any of the preceding claims, wherein the silver halide solvent is a thiosulphate being present in an amount from 0.5 to 5 mole per litre of the correcting agent.

8. A correcting agent according to any of the preceding claims, wherein a sulphite is present in an amount from to 0.06 to 0.6 mole per litre of the correcting agent or a metabisulphite is present in an amount from 0.03 to 0.3 mole per litre of the correcting agent.

9. A correcting agent according to any of the preceding claims, wherein an organic heterocyclic compound, having at least two nitrogen atoms in the heterocyclic nucleus and carrying a mercapto or thione group and not carrying a hydrophylic substituent besides said mercapto or thione group, is present in an amount from 0.04 to 0.4 mole per litre of the correcting agent.

10. A correcting agent according to any of the preceding claims, wherein the thickening agent is a modified polyacrylamide according to Formula I or salts thereof 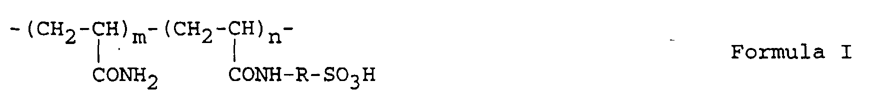 wherein R is an alkylene or substituted alkylene group, an alkenylene or substituted alkenylene group, an arylene or a substituted arylene group, wherein m and n are positive integers and wherein both monomeric units are arranged so as to form a random or block-copolymer.

11. A correcting agent according to any of claims 1 to 9, wherein the thickening agent is a synthetic clay.

12. A felt-tip pen containing a correcting agent according to any of the preceding claims.

13. A felt-tip pen according to claim 12 wherein the tip has a cylindrical diameter form 0.5 to 5 mm.

14. A felt-tip pen according to claim 12 or 13 packaged with a material having an oxygen permeability of not more than 2000 ml/m²·day·atm and a water vapour transmission rate of not more than 40 g/m²·day.
